# EUROPÄISCHE PATENTSCHRIFT

(11) **EP 2 499 402 B1**
(45) Veröffentlichungstag und Bekanntmachung des Hinweises auf die Patenterteilung: **01.01.2014**
(21) Anmeldenummer: 10770787.9
(22) Anmeldetag: 14.10.2010
(51) Int. Cl.: F16J 9/14, F16J 9/26

(54) **KOLBENRING**
PISTON RING
SEGMENT DE PISTON

(30) Priorität: 10.11.2009 DE 102009052587
(43) Veröffentlichungstag der Anmeldung: 19.09.2012
(73) Patentinhaber: Federal-Mogul Burscheid GmbH, 51399 Burscheid (DE)
(72) Erfinder: HERBST-DEDERICHS, Christian, 53332 Bornheim (DE); ESSER, Peter-Klaus, 51515 Kürten (DE); LAMMERS, Ralf, 42929 Wermelskirchen (DE); BRESINSKI, Sebastian, 40764 Langenfeld (DE)
(74) Vertreter: Becker Kurig Straus
(86) Internationale Anmeldenummer: PCT/EP2010/065458
(87) Internationale Veröffentlichungsnummer: WO 2011/057875

(56) Entgegenhaltungen:
- DE-A1-102007 007 960
- JP-A- 2001 295 699

## Beschreibung

Die Erfindung betrifft einen Kolbenring, insbesondere einen Kompressionskolbenring.

Die Laufflächen von Kolbenringen, insbesondere Kompressionskolbenringen in Verbrennungsmotoren, erfahren durch thermische und mechanische Beaufschlagung eine besondere Belastung an den Ringstoßenden. Dies führt dort in der Regel zu übermäßigem Verschleiß und gegebenenfalls zu thermischer Überlastung und nachfolgendem Fressen. Der Stoßbereich ist somit eine der wesentlichen Schwachstellen für die Lebensdauer des Kolbenrings, insbesondere des Kompressionskolbenrings.

Allgemein bekannt ist, Kolbenringe mit harten Beschichtungen zu versehen. Diese können das partielle Phänomen im Bereich der Ringstoßenden jedoch generell nicht verhindern. Zur Entlastung der Stoßbereiche kann die Radialdruck verteilung so optimiert werden, dass der Stoßdruck reduziert wird. Die Einbringung von radialen Querschnittsschwächungen, bevorzugt im ersten und vierten Quadranten, kann eine bestimmte Druckentlastung bewirken. Alle Maßnahmen zusammen haben jedoch insbesondere bei axial niedrigen Kolbenringen das Phänomen der Stoßüberlastung nicht gänzlich beseitigt.

Die US 1,278,015 offenbart einen Kolbenring, der im Stoßbereich dünner ausgeführt ist. Die Lauffläche des Kolbenringes ist mit Zinn beschichtet, wobei diese Zinnschicht am Stoß dünner als im übrigen Umfangsbereich ausgeführt werden kann.

Durch die JP 2000120866 A ist ein Kolbenring bekannt geworden, der eine Lauffläche, obere und untere Flankenbereiche sowie eine innere Umfangsfläche beinhaltet. Der Bereich der inneren Umfangsfläche ist im Bereich der Stoßenden mit einer Querschnittsschwächung versehen.

JP 2001 295 699 A offenbart einen Kolbenring mit einer PVD-Schicht, gemäß den Oberbegriff des Anspruchs 1.

Der Erfindung liegt die Aufgabe zugrunde, zur Reduzierung des übermäßigen Stoßverschleißes, insbesondere bei axial niedrig bauenden Kolbenringen, eine schmierungsverbessernde Laufflächen-Topographie vorzusehen, um auf diese Weise eine verbesserte Standzeit des Kolbenrings zu erreichen.

Diese Aufgabe wird gelöst durch einen Kolbenring, insbesondere Kompressionskolbenring, beinhaltend eine Lauffläche, obere und untere Flankenbereiche, eine innere Umfangsfläche sowie einen Stoß, wobei die Wanddicke des Kolbenrings, über seinen Umfang gesehen, gleich ausgebildet und zumindest die Lauffläche mit einer PVD- oder einer CVD-Schicht versehen ist, dergestalt, dass die Laufflächenschicht im stoßnahen Umfangsbereich eine geringere Schichtstärke als im übrigen Umfangsbereich der Lauffläche aufweist.

Vorteilhafte Weiterbildungen des Erfindungsgegenstandes sind den Unteransprüchen zu entnehmen.

Mit dem Erfindungsgegenstand kann nun im hoch belasteten stoßendennahen Bereich eine andere Oberflächengüte als im restlichen Umfangsbereich des Kolbenrings, insbesondere eines axial niedrig bauenden Kompressionskolbenrings, herbeigeführt werden.

Die Rauheiten im Stoßbereich bewegen sich zwischen 0,8 - 1,2 µm, während die verbleibende Lauffläche beispielsweise in ihrem geläppten Zustand eine Rauheit < 0,08 µm aufweist.

Dadurch, dass der schichtstärkenreduzierte stoßnahe Umfangsbereich des Kolbenrings auch bei einer Bearbeitung der Umfangsfläche des Kolbenrings nicht von dieser Bearbeitung betroffen ist, ist dieser stoßnahe Umfangsbereich gegenüber der verbleibenden Umfangsfläche rauer. Durch diese Maßnahme kann ein besseres Ölspeichervermögen im stoßnahen Bereich erzielt werden.

Ebenfalls denkbar ist, zur Erzielung unterschiedlicher Oberflächengüten, einerseits in den stoßnahen Umfangsbereichen und andererseits im Restbereich des Kolbenrings unterschiedliche abtragende Verfahren einzusetzen, um so gezielt unterschiedliche Laufflächen-Topographien zu erzeugen.

Als abtragendes Verfahren bietet sich hierbei das Läppen an. Der jeweilige stoßnahe Bereich wird, einem weiteren Gedanken der Erfindung gemäß, definiert durch einen von der jeweiligen Stoßkante ausgehenden, einen Umfangswinkel < 20°, insbesondere < 10° umfassenden Abschnitt.

Die Ausführung der Laufflächenschicht am Kolbenring ist so vorzunehmen, dass die Oberfläche im stoßnahen Bereich, selbst nach einer üblichen Einbauprozedur im motorischen Betrieb, nach wie vor erhalten bleibt und durch die gegebenen Verbrennungsbedingungen keine Glättungen erfahren hat.

In Analogie zum Stand der Technik kann es für bestimmte Anwendungsfälle sinnvoll sein, die stoßnahen Umfangsbereiche des Kolbenrings vor der Beschichtung zu reduzieren.

Als PVD-Schichten werden bekannte CrN-, CrON-, CrAIN-, Multi Layer-, DLC-, TI-oder andere hartstoffbasierende Schichten angesehen.

Der Erfindungsgegenstand ist anhand eines Ausführungsbeispiels in der Zeichnung dargestellt und wird wie folgt beschrieben. Es zeigen:
- Figur 1: Draufsicht auf einen erfindungsgemäßen Kolbenring;
- Figur 2: Teilansicht eines der stoßnahen Endbereiche des Kolbenrings gemäß Figur 1.

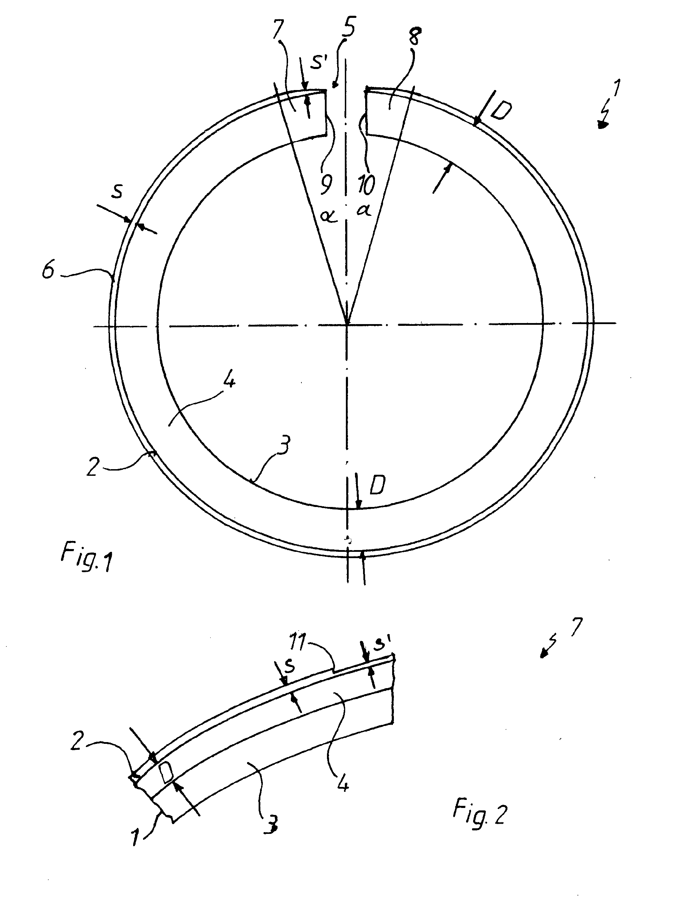

Figur 1 zeigt einen erfindungsgemäßen Kolbenring 1, der in diesem Beispiel durch einen Kompressionskolbenring gebildet sein soll. Der Kolbenring 1 beinhaltet eine äußere Lauffläche 2, eine innere Umfangsfläche 3 sowie obere und untere Flankenbereiche 4. Darüber hinaus verfügt der Kolbenring 1 über einen Stoß 5. Die Wanddicke D des Kolbenrings 1 ist, über seine gesamte Umfangslänge gesehen, im Wesentlichen gleich ausgebildet. Die Lauffläche 2 ist in diesem Beispiel mit einer PVD-Schicht 6, beispielsweise einer CrN-Schicht, versehen. Wie Figur 1 zu entnehmen ist, wird im Bereich des Stoßes 5 jeweils ein stoßnaher Umfangsbereich 7,8 gebildet, der in diesem Beispiel, ausgehend von der jeweiligen Stoßkante 9,10, sich über einen Umfangswinkel α von 10° erstreckt. Außerhalb des jeweiligen stoßnahen Bereichs 7,8 ist die Schichtstärke s gleich ausgebildet. Sie wird für dieses Beispiel mit 30 µm angenommen.

Davon abweichend ist die Schichtstärke s' in den stoßnahen Bereichen 7.8 in diesem Beispiel um 8 µm reduziert, d.h. weist eine Schichtstärke von 22 µm auf. Diese Werte sind angenommene Werte und können, in Abhängigkeit vom jeweiligen Einsatzfall, auch andersartig sein. Nach der Beschichtung der Lauffläche 2 wird die Schicht s einer Umfangsbearbeitung, beispielsweise durch Läppen, unterzogen. Dadurch, dass die Schichtstärke s' geringer dimensioniert ist als die Schichtstärke s wird bei dieser Umfangsbearbeitung in den stoßnahen Bereichen 7,8 kein Materialabtrag generiert. Durch diese Maßnahme wird außerhalb der stoßnahen Bereiche 7,8 somit eine andere Oberflächengüte erzeugt als im jeweiligen stoßnahen Bereich 7,8. In diesem Beispiel soll die CrN-Schicht mit der Materialstärke s' keiner weiteren Oberflächenbehandlung unterworfen werden, so dass selbige im Beschichtungsstatus verbleibt. Somit ist hier eine gegenüber der verbleibenden Umfangsfläche höhere Rauhigkeit gegeben. Selbige soll für dieses Beispiel wie folgt angenommen werden: 0,9 µm im jeweiligen Stoßbereich. Der verbleibende geläppte Laufflächenbereich soll eine Rauheit < 0,05 µm aufweisen. Durch diese in den stoßnahen Bereichen 7,8 erhöhte Rauhigkeit kann ein besseres Ölspeichervermögen erzielt werden.

Figur 2 zeigt eine Teilansicht eines stoßnahen Endbereichs 7. Erkennbar ist die äußere Lauffläche 2, die innere Umfangsfläche 3 und der obere Flankenbereich 4. Ferner erkennbar sind die unterschiedlichen Schichtstärken s und s'. Bei gleich bleibender Wanddicke D des Kolbenrings 1 ist die Schichtstärke s' im stoßnahen Bereich 7 etwas zurückgezogen und wird einer nachfolgenden Umfangsbearbeitung der Lauffläche 2 somit nicht ausgesetzt. Der Übergang von der Schichtstärke s in die Schichtstärke s' wird hier durch einen Absatz 11 gebildet.

## Patentansprüche

1. Kolbenring, insbesondere Kompressionskolbenring, beinhaltend eine Lauffläche (2), obere und untere Flankenbereiche (4), eine innere Umfangsfläche (3) sowie einen Stoß (5), wobei die Wanddicke (D) des Kolbenrings (1), über seinen Umfang gesehen, gleich ausgebildet und zumindest die Lauffläche (2) mit einer einzelnen PVD- oder CVD-Schicht (6) versehen ist, **dadurch gekennzeichnet, dass** die Laufflächenschicht (6) in den stoßnahen Umfangsbereichen (7, 8) ausgehend von einer jeweiligen Stoßkante (9, 10) des Stoßes (5) bis zu einem Umfangswinkel (α) < 20° eine höhere Rauheit als im übrigen Umfangsbereich der Lauffläche (2) und eine geringere Schichtstärke (s') als die Schichtstärke (s) im übrigen Umfangsbereich der Lauffläche (2) aufweist.

2. Kolbenring nach Anspruch 1, wobei die Schichtstärke (s) zwischen 20 und 50 µm beträgt und in den stoßnahen Bereichen (7, 8) um 1 bis 10 µm reduziert ist.

3. Kolbenring nach einem der Ansprüche 1 oder 2, wobei der Übergang von der Schichtstärke (s) in die Schichtstärke (s') im jeweiligen stoßnahen Bereich (7, 8) durch Bildung eines Absatzes (11) erfolgt.

4. Kolbenring nach einem der Ansprüche 1 bis 3, wobei die schichtstärkenreduzierten Umfangsbereiche (7, 8) eine Rauheit im Bereich von 0,8 bis 1,2 µm aufweisen.

5. Kolbenring nach einem der Ansprüche 1 bis 4, wobei die Rauheit außerhalb der schichtstärkenreduzierten Umfangsbereiche (7, 8) < 0,08 µm beträgt.

6. Verfahren zur Herstellung eines Kolbenrings, umfassend:
Bereitstellen eines Kolbenrings, insbesondere Kompressionskolbenring, beinhaltend eine Lauffläche (2), obere und untere Flankenbereiche (4), eine innere Umfangsfläche (3) sowie einen Stoß (5), wobei die Wanddicke (D) des Kolbenrings (1), über seinen Umfang gesehen, gleich ausgebildet ist;
Beschichten zumindest der Lauffläche (2) mit einer einzelnen PVD- oder CVD-Schicht (6), so dass die Laufflächenschicht (6) in den stoßnahen Umfangsbereichen (7, 8) ausgehend von einer jeweiligen Stoßkante (9, 10) des Stoßes (5) bis zu einem Umfangswinkel (α) < 20° eine geringere Schichtstärke (s') als die Schichtstärke (s) im übrigen Umfangsbereich der Lauffläche (2) aufweist; und
Umfangsbearbeiten der Lauffläche (2), so dass die Laufflächenschicht (6) im übrigen Umfangsbereich eine geringere Rauheit als in den stoßnahen Umfangsbereichen (7, 8) erhält.

7. Verfahren nach Anspruch 6, wobei das Verhältnis der unterschiedlichen Schichtstärken (s: s') dergestalt ist, dass bei der sich an die Beschichtung anschließenden Umfangsbearbeitung der Lauffläche (2), respektive der Laufflächenschicht (6), der jeweilige stoßnahe Bereich (7, 8) des Kolbenrings (1) der Umfangsbearbeitung nicht ausgesetzt wird.

8. Verfahren nach Anspruch 6 oder 7, wobei der schichtstärkenreduzierte Umfangsbereich (7, 8) bei der Bearbeitung der Lauffläche (2), respektive der Laufflächenschicht (6), im Zustand der Beschichtung verbleibt.

9. Verfahren nach einem der Ansprüche 6 bis 8, wobei die Umfangsbearbeitung Läppen umfasst.

10. Verfahren nach einem der Ansprüche 6 biss 9, wobei die Umfangsbearbeitung in den stoßnahen Umfangsbereichen (7, 8) einerseits und dem übrigen Umfangsbereich andererseits unterschiedliche Material abtragende Verfahren einsetzt.

## Claims

1. A piston ring, in particular a compression piston ring, including a running surface (2), upper and lower flank areas (4), an inner peripheral surface (3), and a joint (5), wherein the wall thickness (D) of the piston ring (1), considered over its periphery, is implemented as equal and at least the running surface (2) is provided with a single PVD or CVD layer (6) **characterized in that** the running surface layer (6), in the peripheral areas (7, 8) close to the joint originating from a respective joint edge (9, 10) of the joint (5) up to a peripheral angle (?) <20°, has a greater roughness than in the remaining peripheral area of the running surface (2) and a lesser layer thickness (s') than the layer thickness (s) in the remaining peripheral area of the running surface (2).

2. The piston ring according to Claim 1, wherein the layer thickness (s) is between 20 and 50 µm and is reduced by 1 to 10 µm in the areas (7, 8) close to the joint.

3. The piston ring according to one of Claims 1 or 2, wherein the transition from the layer thickness (s) into the layer thickness (s') in the respective area (7, 8) close to the joint is performed by forming a recess (11).

4. The piston ring according to one of Claims 1 to 3, wherein the peripheral areas (7, 8) reduced in layer thickness have a roughness in the range from 0.8 to 1.2 µm.

5. The piston ring according to one of Claims 1 to 4, wherein the roughness outside the peripheral areas (7, 8) reduced in layer thickness is < 0.08 µm.

6. A method for producing a piston ring, comprising:
providing a piston ring, in particular a compression piston ring, including a running surface (2), upper and lower flank areas (4), an inner peripheral surface (3), and a joint (5), the wall thickness (D) of the piston ring (1) being implemented as equal considered over its periphery;
coating at least the running surface (2) using a single PVD or CVD layer (6), so that the running surface layer (6) in the peripheral areas (7, 8) close to the joint originating from a respective joint edge (9, 10) of the joint (5) up to a peripheral angle (?) <20°,
has a lesser layer thickness (s') than the layer thickness (s) in the remaining peripheral area of the running surface (2); and
peripheral processing of the running surface (2), so that the running surface layer (6) receives a lesser roughness in the remaining peripheral area than in the peripheral areas (7, 8) close to the joint.

7. The method according to Claim 6, wherein the ratio of the different layer thicknesses (s:s') is such that during the peripheral processing of the running surface (2), or the running surface layer (6), following the coating, the respective area (7, 8) of the piston ring (1) close to the joint is not subjected to the peripheral processing.

8. The method according to Claim 6 or 7, wherein the peripheral area (7, 8) reduced in layer thickness remains in the state of the coating during the processing of the running surface (2), or the running surface layer (6).

9. The method according to one of Claims 6 to 8, wherein the peripheral processing comprises lapping.

10. The method according to one of Claims 6 to 9, wherein the peripheral processing uses different material operating methods in the peripheral areas (7, 8) close to the joint, on the one hand, and the remaining peripheral area, on the other hand.

## Revendications

1. Segment de piston, notamment segment de piston de compression, contenant une surface de roulement (2), une région de flanc supérieur et inférieur (4), une surface circonférentielle (3) intérieure ainsi qu'une butée (5), dans lequel l'épaisseur de paroi (D) du segment de piston (1), vue sur sa circonférence, est conçue de manière égale et au moins la surface de roulement (2) est pourvue d'une couche individuelle obtenue par dépôt physique en phase vapeur ou par dépôt chimique en phase vapeur, **caractérisé en ce que** la couche de surface de roulement (6) présente dans les zones circonférentielles (7,8à) proches de la butée à partir d'une arête de butée respective (9,10) de la butée (5) jusqu'à un angle circonférentiel (α) < 20° une plus grande rugosité que dans le reste de la zone circonférentielle de la surface de roulement (2) et une épaisseur de couche (s') plus petite que l'épaisseur de couche (s) dans le reste de la zone circonférentielle de la surface de roulement (2).

2. Segment de piston selon la revendication 1, dans lequel l'épaisseur de paroi (s) est comprise entre 20 et 50 pm et est réduite de 1 à 10 µm dans les zones proches de la butée (7,8).

3. Segment de piston selon une des revendications 1 ou 2, dans lequel la transition de l'épaisseur de paroi (s) à l'épaisseur de paroi (s') dans la zone proche de la butée (7,8) respective a lieu par la formation d'un épaulement (11).

4. Segment de piston selon une des revendications 1 à 3, dans lequel les zones circonférentielles (7,8) à épaisseur de couche réduite présentent une rugosité comprise dans une plage de 0,8 à 1,2 µm.

5. Segment de piston selon une des revendications 1 à 4, dans lequel la rugosité à l'extérieur des zones circonférentielles (7,8) à épaisseur de couche réduite s'élève à < 0,08 µm.

6. Procédé de fabrication d'un segment de piston, comprenant :
la fourniture d'un segment de piston, notamment d'un segment de piston de compression, contenant une surface de roulement (2), une région de flanc supérieure et inférieure (4), une surface circonférentielle intérieure (3) ainsi qu'une butée (5), dans lequel l'épaisseur de paroi (D) du segment de piston (1), vue sur sa circonférence, est conçue de manière égale ;
le revêtement d'au moins la surface de roulement (2) avec une couche (6) individuelle obtenue par dépôt physique ou dépôt chimique en phase vapeur, de sorte que la couche de surface de roulement (6) présente dans les zones circonférentielles (7,8) proches de la butée à partir d'une arête de butée respective (9,10) de la butée (5) jusqu'à un angle circonférentiel (α) < 20° une épaisseur de couche plus petite (s') que l'épaisseur de couche (s) dans le reste de la région circonférentielle de la surface de roulement (2) ; et
l'usinage sur la circonférence de la surface de roulement (2), de telle sorte que l'épaisseur de la surface de roulement (6) acquière dans le reste de la zone circonférentielle une rugosité plus petite que dans les zones circonférentielles proches de la butée (7,8).

7. Procédé selon la revendication 6, dans lequel le rapport des différentes épaisseurs de couches (s : s') est tel que lors de l'usinage sur la circonférence de la surface de roulement (2), consécutif au revêtement, respectivement de la couche de surface de roulement (6), la zone respectivement proche de la butée (7,8) du segment de piston (1) n'est pas soumise à un usinage sur sa circonférence.

8. Procédé selon les revendications 6 ou 7, dans lequel la zone circonférentielle (7,8) à épaisseur de couche réduite reste en l'état du revêtement lors de l'usinage de la surface de roulement (2), respectivement de la couche de surface de roulement (6).

9. Procédé selon une des revendications 6 à 8, dans lequel l'usinage sur la circonférence comprend un rodage.

10. Procédé selon une des revendications 6 à 9, dans lequel l'usinage sur la circonférence dans les zones circonférentielles (7,8) proches de la butée d'une part et du reste de la zone circonférentielle d'autre part emploie un procédé d'enlèvement de matériau différent.
